# EUROPEAN PATENT SPECIFICATION

(11) **EP 2 194 391 B1**
(45) Date of publication and mention of the grant of the patent: **04.04.2012**
(21) Application number: 09177168.3
(22) Date of filing: 26.11.2009
(51) Int. Cl.: G01R 33/05, G01R 33/07

(54) **Broad range magnetic sensor and manufacturing process thereof**
Magnetischer Sensor mit grossem Messbereich und Herstellungsprozess für den Sensor
Capteur magnétique à large gamme et procède de fabrication

(30) Priority: 03.12.2008 IT TO20080897
(43) Date of publication of application: 09.06.2010
(73) Proprietor: STMicroelectronics S.r.l., 20041 Agrate Brianza (MB) (IT)
(72) Inventor: Riva, Caterina, 20090 Cusago (IT); Morelli, Marco, 20010 Bareggio (IT); Marchesi, Marco, 29011 Borgonovo Val Tidone (IT)
(74) Representative: Jorio, Paolo

(56) References cited:
- US-A1- 2002 056 202
- US-B1- 6 404 192
- US-B1- 7 046 002
- ANDREA BASCHIROTTO; ENRICO DALLAGO; PIERO MALCOVATI; MARCO MARCHESI; GIUSEPPE VENCHI: "A Fluxgate Magnetic Sensor: From PCB to Micro-Integrated Technology" IEEE TRANSACTIONS ON INSTRUMENTATION AND MEASUREMENT, IEEE SERVICE CENTER, PISCATAWAY, NJ, US, vol. 55, no. 1, 1 February 2007 (2007-02-01), pages 25-31, XP011155761 ISSN: 0018-9456

## Description

The present invention relates to a broad-range magnetic sensor and a corresponding manufacturing process.

Among high-sensitivity magnetic-field sensors capable of detecting low-intensity magnetic fields, the magnetic sensor known as fluxgate sensor offers the best compromise between cost and performance (see, for example, the planar fluxgate sensor described in US 6,404,192). In practice, a planar fluxgate sensor comprises a magnetic core, of a generally elongated shape, overlying an energizing coil. By supplying the energizing coil with an appropriate a.c. excitation current, it is possible to bring the magnetic core into a series of cycles of magnetic saturation. Sensing of external fields is obtained via a pair of sensing coils, generally set underneath the ends of the magnetic core.

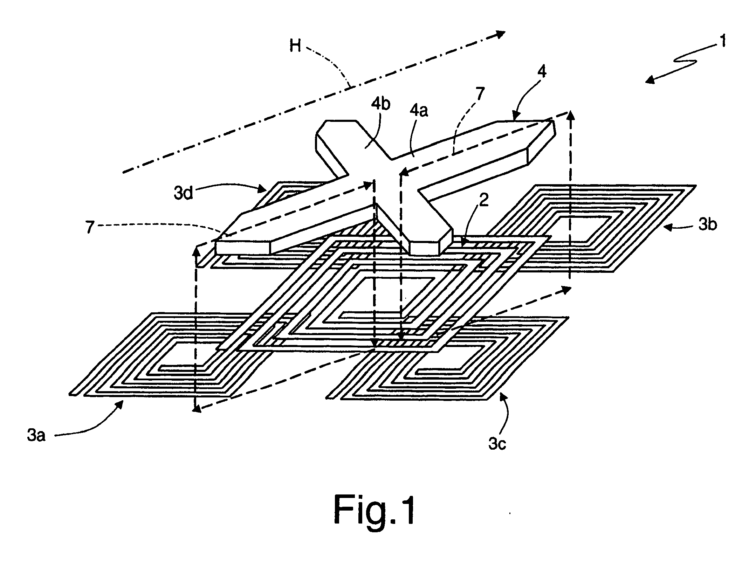

For a better understanding, reference is made to Figure 1, which shows a fluxgate sensor 1 with double sensitivity axis, of the type described in the aforementioned US patent. The fluxgate sensor 1 comprises an energizing coil 2 overlying four sensing coils 3a, 3b, 3c and 3d and underlying a magnetic core 4. In detail, the energizing coil 2 is generally square-shaped, and the magnetic core 4 is cross-shaped and includes a first arm 4a and a second arm 4b, perpendicular to one another. The sensing coils 3a-3d are set in pairs, with vertical axes passing in the proximity of the ends of the arms 4a, 4b of the magnetic core 4, with the sensing coils 3a, 3b aligned to one another and parallel to a first diagonal of the energizing coil 2 and to the axis of the first arm 4a, and the sensing coils 3c, 3d aligned to one another and parallel to a second diagonal of the energizing coil 2 and to the axis of the second arm 4b.

Considering initially only the first arm 4a and the sensing coils 3a, 3b, if the energizing coil is supplied with an appropriate excitation current, able to cause saturation of the magnetic material at an appropriate frequency, the two halves of the first arm 4a are magnetized in opposite directions, as is shown by the arrows 7 in Figure 1. In the absence of an applied external magnetic field, the two sensing coils 3a, 3b experience two equal and zero induced voltages, if they have been connected in a differential configuration.

Instead, if an external magnetic field is applied (arrow H in Figure 1), a first half of the first arm 4a (in the case shown, the left half in the drawing) is magnetized in the same direction as the external field M, thus amplifying its own total magnetization, whereas a second half of the first arm 4a (here, the half on the right in the drawing) is magnetized in an opposite direction, and its total magnetization is reduced. It follows that the differential voltage of the sensing coils 3a, 3b is non-zero and is amplitude modulated by the intensity of the external field M.

The presence of the second arm 4b of the magnetic core enables detection of magnetic fields having a direction perpendicular to the external field M and bestows upon the magnetic sensor 1 two sensitivity axes.

With the fluxgate technology it is possible to provide sensors able to measure d.c. or slowly variable magnetic fields, of an intensity comprised between a few µG and a few G, with a high resolution, of the order of nG. In terms of dynamic range and resolution, the fluxgate devices fall between Hall-effect magnetic-field sensors (which are typically able to detect fields comprised between 10 G and 10⁶ G) and SQUIDs (Superconducting Quantum Interference Devices, which are typically able to detect fields comprised between 10⁻¹⁰ and 10⁻⁵ G).

For low values of the magnetic field, fluxgate sensors are preferable to Hall-effect sensors on account of their better performance, and find a wider application as compared to SQUID sensors, thanks to their lower cost and encumbrance. Thus, fluxgate sensors could find application in either portable or non-portable systems where Hall sensors do not have a sufficient sensitivity.

However, in order to continue to exploit the widespread knowledge on the technologies for the production of Hall sensors, there exist solution in which an attempt has been made to extend the sensitivity of Hall sensors to the range of fluxgate sensors, exploiting the addition, to a Hall sensor, of magnetic material (or concentrator, see, for example, US 6,545,462; US 6,184,679 and US 7,235,968).

These solutions, however, still do not enable the same performance that can be obtained via the fluxgate sensors.

US2002/0056202 discloses an hybrid three-axis magnetic sensor including a fluxgate type magnetic sensor formed as a base a Hall element chip.

The aim of the present invention is thus to provide a magnetic sensor that overcomes the limitations of known sensors.

According to the present invention there are provided a magnetic sensor, the corresponding manufacturing process, a magnetometer, and an electronic apparatus, as defined in claims 1, 6, 9 and 11.

In practice, the present sensor is formed by the superposition of a fluxgate sensor and of a Hall sensor provided with concentrator, and the magnetic core of the fluxgate sensor forms also a concentrator for the Hall-effect sensor.

For a better understanding of the present invention, an embodiment thereof is now described, purely by way of nonlimiting example, with reference to the attached drawings, wherein:
- Figure 1 is a perspective top plan view of a fluxgate sensor with two sensitivity axes;
- Figure 2 is a cross-sectional view of an embodiment of a magnetic sensor according to the invention;
- Figures 3-7 are cross-sectional views through the present magnetic sensor, in successive manufacturing steps;
- Figure 8 shows a block diagram of a magnetometer including the magnetic sensor of Figure 2;
- Figure 9 shows a possible application of the magnetometer of Figure 7; and
- Figure 10 shows a block diagram of an electronic apparatus including the magnetometer of Figure 7.

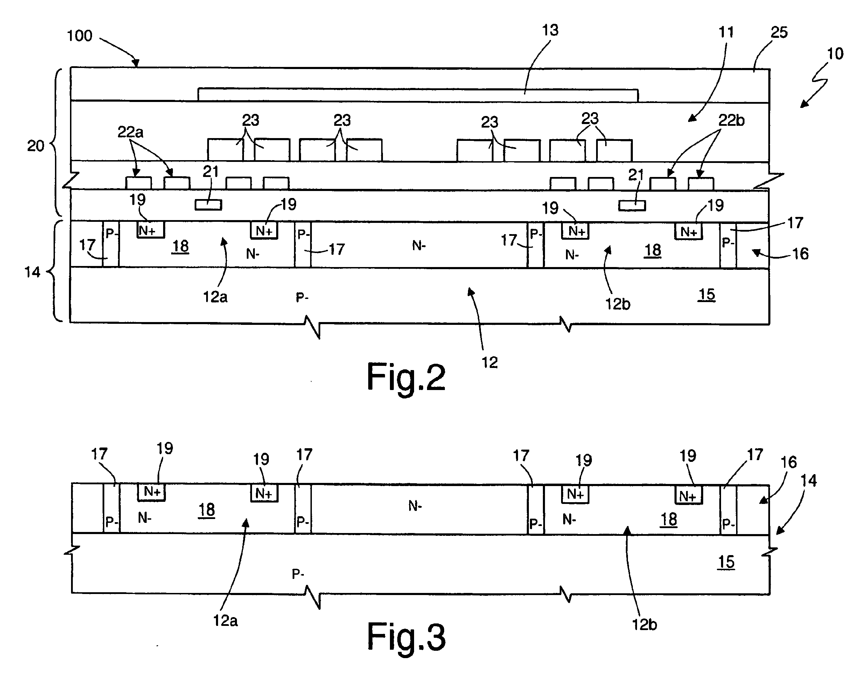

Figure 2 shows a possible embodiment of a magnetic sensor 10, obtained using a CMOS technology and comprising a fluxgate sensor 11 and a Hall sensor 12.

The fluxgate sensor 11 is, for example, obtained as the fluxgate sensor of Figure 1 and comprises a magnetic region 13 having a cross shape and forming both the magnetic core of the fluxgate sensor and a concentrator for the Hall sensor 12. In the example illustrated, the Hall sensor 12 is formed by four Hall-effect cells, two for each arm of the magnetic region 13 forming the magnetic concentrator. In the figure, only two Hall-effect cells 12a, 12b are visible, set underneath a first arm of the magnetic region 13, corresponding to the first arm 4a of Figure 1. Two further Hall-effect cells (not visible) are set underneath a second arm of the magnetic region 13, corresponding to the second arm 4b of Figure 1. All the Hall-effect cells (the cells 12a, 12b and the non-visible ones) are integrated in a single chip 100.

In detail, in the embodiment of Figure 2, a body 14 of semiconductor material comprises a substrate 15, of a P⁻ type, and an epitaxial layer 16, of an N⁻ type. The epitaxial layer 16 houses the Hall-effect cells 12a, 12b, separated from one another by insulation regions 17 of a P⁻ type, which delimit active regions 18 accommodating conductive regions 19 of an N⁺ type, as well as further conductive sensing regions (not visible in Figure 2). In addition, the epitaxial layer 16 may also house, in a way not shown, further components forming supply/control circuitries of the sensors 11, 12 and/or further circuits functionally associated to the magnetic sensor 10.

An insulating material layer 20 extends on the body 14 and is formed by a plurality of layers arranged on top of one another and embedding the fluxgate sensor 11. In particular, the fluxgate sensor 11 is formed in three metallization levels and by the magnetic region 13. In detail, a first metallization level forms connection lines 21, a second metallization level forms sensing coils (here only two are visible, designated by 22a and 22b), and a third metallization level forms an energizing coil 23.

The connection lines 21 are connected, through plugs (not illustrated), to the sensing coils 22a, 22b and enable electrical connection thereof to a supply/control circuitry (not shown), for example, integrated in the epitaxial layer 16. Similar connection lines (not shown) may enable connection of the energizing coil 2 to the respective supply/control circuitry.

The magnetic region 13 is made of a ferromagnetic material having the following characteristics:
- a low value of saturation magnetization Bₛₐₜ so as to require a low power to bring the material into saturation; for example, Bₛₐₜ can have a value of approximately 0.5T;
- a high value of permeability up to the frequency of operation of the device integrating the magnetic sensor 10; for example, the relative permeability µᵣ can be equal to 35,000 at 100 kHz.

In particular, if the magnetic region 13 is made of NiFe (permalloy), it has a saturation magnetization Bₛₐₜ of 1T and a relative permeability of approximately 3,500 at 500 MHz. Alternatively, NiFeMo or other appropriately developed dedicated magnetic alloys can be used.

A passivation layer 25 extends on the magnetic region 13.

In practice, the presence of the Hall sensor 12 underneath the fluxgate sensor 11 enables exploitation of the magnetic region 13 for measuring magnetic fields having an intensity greater than the upper limit of the range of sensitivity of the fluxgate sensor 11, extending the sensitivity of the resulting magnetometer.

In fact, as is known, operation of the Hall-effect cells 12 is based upon detection of the Hall voltage between pairs of conductive regions extending in a direction transverse to the conductive regions 19, as a result of the interaction between a current flowing between the conductive regions 19 themselves and an external magnetic field, orthogonal to the current and, in the case considered, to the surface of the body 14. The magnetic region 13 acts here as concentrator and has the purpose of modifying the lines of magnetic flux of an external magnetic field parallel or co-planar to the surface of the body 14 so that the lines of flux traverse vertically the Hall-effect cells 12 arranged underneath the ends of the magnetic region 13, in addition to providing amplification. In this way, a magnetic field parallel or co-planar to the surface of the body 14 becomes detectable by the Hall-effect cells 12, as is, for example, described in Christian Shott et al., "A CMOS Single-Chip Electronic Compass with Microcontroller", 2007 IEEE International Solid-State Circuit Conference, ISSCC 2007/SESSION 21/SENSORS AND MEMS/21.2.

The magnetic sensor 10 of Figure 2 is manufactured as described hereinbelow.

Initially (Figure 3), junctions N and P intended to form the insulation regions 17, the conductive regions 19, and possible other regions envisaged by the magnetic sensor 10, are implanted and diffused in the epitaxial layer 16, in a per se known manner.

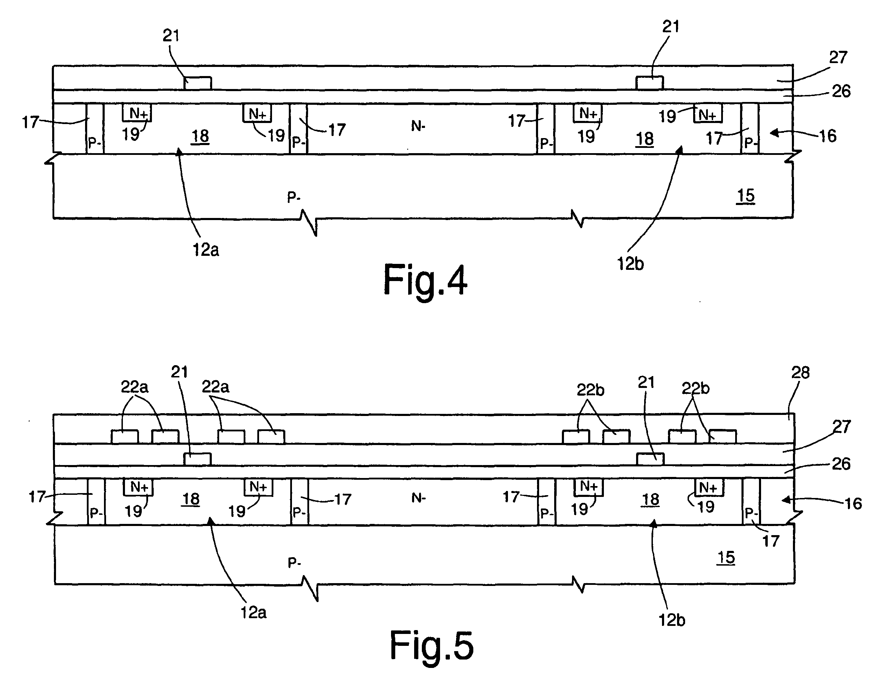

Then (Figure 4), a first dielectric layer 26 is deposited; plugs are formed (not illustrated; for example, they may be of metal) to contact the conductive regions formed in the body 14, in particular with the conductive regions 19; a first metal layer is deposited and defined for providing connection lines 21 and possible further first-level connections envisaged by the device; a second dielectric layer 27 is deposited, and plugs are formed (not illustrated; for example, they may be of metal) to contact the connection lines 21.

Next (Figure 5), a second metal layer is deposited and defined, to provide the sensing coils 22a, 22b and possible further second-level metal connection regions; a third dielectric layer 28 is deposited, and plugs are formed (not illustrated; for example, they may be made of metal) to contact the energizing coil 23.

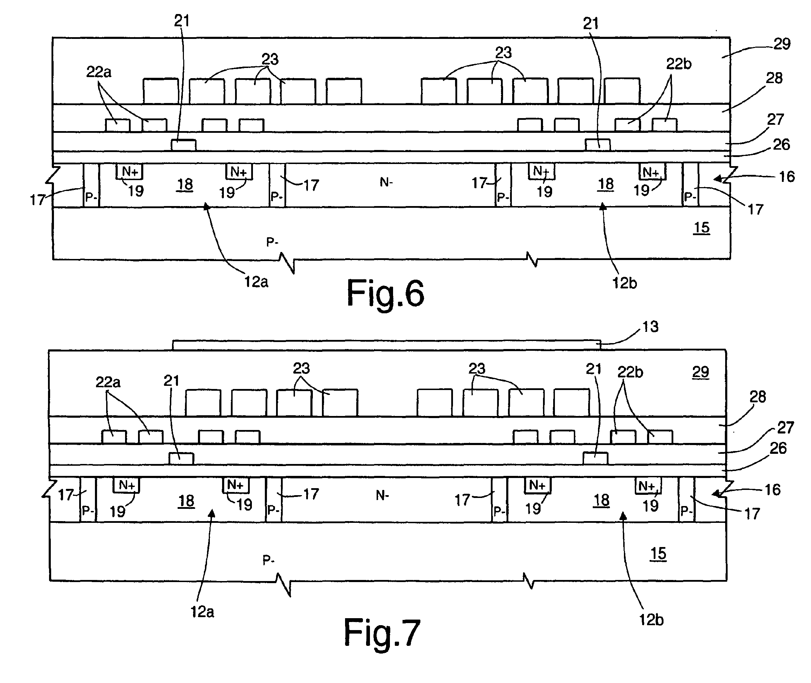

Then (Figure 6), a third metal layer is deposited and defined to obtain the energizing coil 23, and a fourth dielectric layer 29 is deposited.

Next (Figure 7), via a post-machining process, the magnetic material which is to form the magnetic region 13 is deposited.

The magnetic material is deposited via sputtering so as to obtain a typical thickness around 1-5 µm. The sputtering technique (see, for example, Andrea Baschirotto et al., "An integrated microFluxgate sensor with sputtered ferromagnetic core", IMTC 06), enables provision of amorphous thin films with the indicated thickness so as to require a lower power consumption in order to saturate as compared to thicker layers deposited with other techniques (for example, by electroplating).

Finally, the deposited ferromagnetic layer is defined so as to have the cross shape, and the passivation layer 25 is deposited so as to cover the magnetic region 13, in order to obtain the structure of Figure 2.

The sensor described herein has numerous advantages. In fact, it represents a device capable of operating on the set of ranges of sensitivity of a fluxgate sensor and of a Hall sensor with magnetic concentrator, greatly extending the possible applications of the resulting magnetometer.

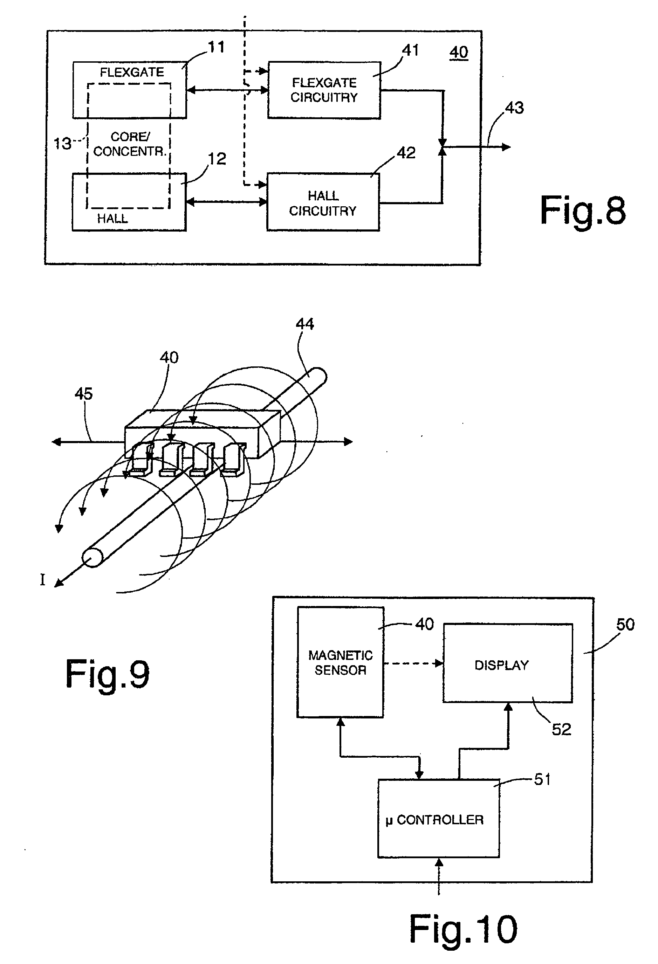

The magnetic sensor 10 can be integrated alone or be integrated in the same chip with the respective supply/control circuitries. Figure 8 shows, for example, a block diagram of a magnetometer 40, comprising the fluxgate sensor 11, the Hall sensor 12, a fluxgate supply/control circuitry 41, and a Hall supply/control circuitry 42. In the diagram of Figure 8, dashed arrows represent possible external control signals for controlling, if desired, selective turning-on of the fluxgate portion and/or of the Hall portion. The outputs of the circuitries 41, 42 are here connected to a single output 43 of the magnetometer. Alternatively or in addition, separate outputs may be envisaged.

The magnetometer 40 has a multiplicity of possible applications. For example, it can be used as current meter, as is shown in Figure 9. In fact, by setting a wire 44 on or underneath the magnetometer 40, possibly oriented perpendicular to the sensitive axis 45 of the magnetometer 40 (if it has a single sensitivity axis), it is able to measure a current I flowing in the wire 44 without any resistive losses and without interrupting or interfering with operation of the circuit to which the wire 44 belongs. In this case, the output of the magnetometer 40 can be simply connected to an appropriate display (not shown).

The magnetometer 40 can also be used as electronic compass, for example, in a cellphone or other electronic apparatus having navigation functions. In this case, as is shown in Figure 10, an apparatus 50 having navigation functions may comprise the magnetometer 40 and a microcontroller 51, which is connected with the magnetometer 40 and with a display 52 and receives control signals from outside through purposely provided interfaces (not illustrated).

Further possible applications comprise, among other things, apparatuses for detecting physiological parameters (heartbeat, cerebral waves, blood pressure, etc.), position detectors (whether linear or rotary, for example, for knobs, cursors, joysticks and the like, or mobile members, such as pistons, etc.), level indicators, and so on.

Finally, it is clear that modifications and variations can be made to the magnetic sensor and to the corresponding manufacturing process, described and illustrated herein, without thereby departing from the scope of the present invention, as defined in the annexed claims. For example, even though Figure 2 shows a sensor including two Hall-effect cells, wherein each Hall-effect cell is arranged at a respective end of the magnetic region 13, the sensor could be obtained by increasing the number of cells arranged at each end of the magnetic region 13, and/or in an intermediate position. In addition, the shape of the core/concentrator can differ from the one illustrated; for example, the fluxgate sensor can have a single sensitivity axis with a single arm, and/or each arm may have a different shape, with the Hall-effect cells arranged underneath the ends of the magnetic region; the configuration and number of the sensing coils could be different; for example, a single sensing coil or a pair of sensing coils not in differential configuration could be provided. Alternatively, it is possible to provide two sensing coils arranged vertically on top of one another, wherein the underlying coil is used as feedback to increase the range of linearity and the sensitivity.

## Claims

1. A magnetic sensor, comprising a fluxgate sensor (11) and a Hall sensor (12), **characterized in that** the fluxgate sensor (11) is formed in an insulating layer (20) overlying a body (14) of semiconductor material accommodating the Hall sensor (12), the fluxgate sensor being integrated in a same chip (100) with the Hall sensor and comprising an energizing coil (23), at least one sensing coil (22a, 22b) and a magnetic core (13) formed in the insulating layer (20), and the Hall sensor (12) comprising conductive regions (19) accommodated in said body and a magnetic concentrator (13) formed in the insulating layer (20), the magnetic sensor comprising a magnetic region (13) forming both said magnetic core and said magnetic concentrator.

2. A magnetic sensor according to claim 1, wherein said magnetic region (13) extends on said insulating layer, above said energizing coil (23), said sensing coils (22a, 22b) and said conductive regions.

3. A magnetic sensor according to claim 2, wherein said energizing coil (23) and sensing coils (22a, 22b) are formed in distinct metallization levels and said magnetic region (13) is formed by a ferromagnetic material layer deposited by sputtering.

4. A magnetic sensor according to claim 2 or 3, wherein said magnetic region (13) has an elongated structure provided with a first and a second ends, said fluxgate sensor (11) comprises a first and a second sensing windings (22a, 22b), and said Hall sensor (12) comprises a first and a second Hall-effect cell (12a, 12b), said first sensing winding and said first Hall-effect cell being arranged vertically under said first end, and said second sensing winding and said second Hall-effect cell being arranged vertically under said second end.

5. A process for manufacturing a magnetic sensor, comprising the step of:
providing a body (14) of semiconductor material;
forming a Hall sensor (12) in the body;
forming an insulating layer (20) on said body;
forming a fluxgate sensor (11) in said insulating layer, thereby the Hall sensor and the fluxgate sensor are integrated in a same chip (100), wherein the step of forming a fluxgate sensor (11) and a Hall sensor (12) comprises the steps of:
forming conductive regions (19) within said body;
forming an energizing coil (23) and a sensing coil (22a, 22b) in said insulating layer; and
forming a magnetic region (13) on said insulating layer (20), above said energizing and sensing coils, and above said conductive regions, said magnetic region forming both a magnetic core for said fluxgate sensor and a magnetic concentrator for said Hall sensor.

6. A process according to claim 5, wherein the steps of forming an insulating layer, an energizing coil, and a sensing coil comprise:
depositing a dielectric layer (26-27);
depositing a metallization level;
defining said metallization level to obtain said sensing coil (22a, 22b);
depositing a subsequent dielectric layer (28);
depositing a subsequent metallization level;
defining said subsequent metallization level to obtain said energizing coil (23);
depositing a further dielectric layer (29); and
depositing by sputtering said magnetic region (13).

7. A magnetometer (40), comprising the magnetic sensor (10) according to any one of claims 1-4, and including a fluxgate sensor supply/control circuitry (41) and a Hall sensor supply/control circuitry (42).

8. A magnetometer according to claim 7, wherein said supply/control circuitries for the fluxgate sensor and the Hall sensor (41, 42) are integrated in said chip (100).

9. A magnetometer according to claim 7 or 8, wherein the fluxgate sensor supply/control circuitry (41) and Hall sensor supply/control circuitry (42) have own distinct inputs configured to receive external distinct control signals.

10. An electronic apparatus (50), comprising a control unit (51), a display (52), and a magnetometer (40) according to any of claims 7-9

## Patentansprüche

1. Magnetsensor mit einem Fluxgatesensor (11) und einem Hallsensor (12) **dadurch gekennzeichnet, dass** der Fluxgatesensor (11) in einer isolierenden Schicht (20) ausgebildet ist, die über einem Körper (14) aus Halbleitermaterial liegt, der den Hallsensor (12) beherbergt, wobei der Fluxgatesensor zusammen mit dem Hallsensor in einem gemeinsamen Chip (100) integriert ist und aufweist: eine Erregerspule (23), wenigstens eine Sensorspule (22a, 22b) und einen magnetischen Kern (13), die in der isolierenden Schicht (20) ausgebildet sind, wobei der Hallsensor leitende Bereichen (19), die in dem Körper beherbergt sind, und einen magnetischen Konzentrator (13) aufweist, der in der isolierenden Schicht (20) ausgebildet ist, wobei der Magnetsensor einen magnetischen Bereich (13) aufweist, der sowohl den magnetischen Kern als auch den magnetischen Konzentrator bildet.

2. Magnetsensor nach Anspruch 1, wobei sich der magnetische Bereich (13) auf der isolierenden Schicht oberhalb der Erregerspule (23), der Sensorspulen (22a, 22b) und der leitfähigen Bereiche erstreckt.

3. Magnetsensor nach Anspruch 2, wobei die Erregerspule (23) und die Sensorspulen (22a, 22b) in unterschiedlichen Metallisierungsebenen ausgebildet sind und der magnetische Bereich (13) durch eine Schicht aus ferromagnetischen Material gebildet wird, die durch Sputtern aufgebracht worden ist.

4. Magnetsensor nach Anspruch 2 oder 3, wobei der magnetische Bereich (13) eine längliche Struktur mit einem ersten und einem zweiten Ende hat, der Fluxgatesensor (11) eine erste und eine zweite Sensorspule (22a, 22b) aufweist und der Hallsensor (12) eine erste und eine zweite Halleffektzelle (12a, 12b) aufweist, wobei die erste Sensorspule und die erste Halleffektzelle vertikal unter dem ersten Ende angeordnet sind und die zweite Sensorspule und die zweite Halleffektzelle vertikal unter dem zweiten Ende angeordnet sind.

5. Verfahren zum Herstellen eines Magnetsensors mit den Schritten:
Bereitstellen eines Körpers (14) aus Halbleitermaterial;
Ausbilden eines Hallsensors (12) in dem Körper;
Ausbilden einer isolierenden Schicht auf dem Körper;
Ausbilden eine Fluxgatesensors (11) in der isolierenden Schicht, wobei der Hallsensor und der Fluxgatesensor in dem gleichen Chip (100) integriert sind,
wobei der Schritt des Ausbildens des Fluxgatesensors (11) und des Hallsensors (12) die Schritte einschließt:
Ausbilden leitender Bereiche (19) innerhalb des Körpers;
Ausbilden einer Erregerspule (23) und einer Sensorspule (22a, 22b) in der isolierenden Schicht; und
Ausbilden eines magnetischen Bereichs (13) auf der isolierenden Schicht (20) oberhalb der Erreger- und der Sensorspulen und oberhalb der leitfähigen Bereiche, wobei die magnetischen Bereiche sowohl einen magnetischen Kern für den Fluxgatesensor als auch einen magnetischen Konzentrator für den Hallsensor bilden.

6. Verfahren nach Anspruch 5, wobei die Schritte des Ausbildens einer isolierenden Schicht, einer Erregerspule und einer Sensorspule einschließen:
Ablagern einer dielektrischen Schicht (26-27);
Ablagern einer Metallisierungsebene;
Abgrenzen der Metallisierungsebene, um die Sensorspule (22a, 22b) zu erhalten;
Ablagern einer folgenden dielektrischen Schicht (28);
Ablagern einer folgenden Metallisierungsebene;
Abgrenzen der folgenden Metallisierungsebene um die Erregerspule (23) zu erhalten;
Ablagern einer weiteren dielektrischen Schicht (29); und
Ablagern des magnetischen Bereichs (13) durch Sputtern.

7. Magnetometer (40) mit dem Magnetsensor (10) nach einem der Ansprüche 1 bis 4, dass eine Fluxgatesensor-Bereitstellungs-und Steuerschaltung (41) und eine Hallsensor-Bereitstellungs- und Steuerschaltung (42) aufweist,

8. Magnetometer nach Anspruch 7, wobei die Bereitstellungs- und Steuerschaltungen für den Fluxgatesensor und für den Hallsensor (41, 42) in dem Chip (100) integriert sind.

9. Magnetometer nach Anspruch 7 oder 8, wobei die Fluxgatesensor-Bereitstellungs-und Steuerschaltung (41) und die Hallsensor-Bereitstellungs- und Steuerschaltung (42) ihre eigenen voreinander getrennten Eingänge haben, die eingerichtet sind, getrennte äußere Steuersignale entgegen zu nehmen.

10. Elektrische Vorrichtung (15) mit einer Steuereinheit (51), einer Anzeigevorrichtung (52) und einem Magnetometer (40) nach einem der Ansprüche 7 bis 9.

## Revendications

1. Capteur magnétique comprenant un capteur à vanne de flux (11) et un capteur de Hall (12), **caractérisé en ce que** le capteur à vanne de flux (11) est formé dans une couche isolante (20) recouvrant un corps (14) d'un matériau semi-conducteur logeant le capteur de Hall (12), le capteur à vanne de flux étant intégré dans une même puce (100) avec le capteur de Hall et comprenant une bobine d'excitation (23), au moins une bobine de détection (22a, 22b) et un noyau magnétique (13) formé dans la couche isolante (20), et le capteur de Hall (12) comprenant des régions conductrices (19) logées dans ledit corps et un concentrateur magnétique (13) formé dans la couche isolante (20), le capteur magnétique comprenant une région magnétique (13) formant à la fois ledit noyau magnétique et ledit concentrateur magnétique.

2. Capteur magnétique selon la revendication 1, dans lequel ladite région magnétique (13) s'étend sur ladite couche isolante, au-dessus de ladite bobine d'excitation (23), desdites bobines de détection (22a, 22b) et desdites régions conductrices.

3. Capteur magnétique selon la revendication 2, dans lequel ladite bobine d'excitation (23) et lesdites bobines de détection (22a, 22b) sont formées dans des niveaux de métallisation distincts et ladite région magnétique (13) est formée par une couche de matériau ferromagnétique déposée par pulvérisation.

4. Capteur magnétique selon la revendication 2 ou 3, dans lequel ladite région magnétique (13) a une structure allongée munie d'une première et d'une deuxième extrémités, ledit capteur à vanne de flux (11) comprend un premier et un deuxième enroulements de détection (22a, 22b) et ledit capteur de Hall (12) comprend une première et une deuxième cellules à effet Hall (12a, 12b), ledit premier enroulement de détection et ladite première cellule à effet Hall étant agencés verticalement sous ladite première extrémité, et ledit deuxième enroulement de détection et ladite deuxième cellule à effet Hall étant agencés verticalement sous ladite deuxième extrémité.

5. Procédé de fabrication d'un capteur magnétique comprenant les étapes de :
fourniture d'un corps (14) en matériau semi-conducteur ;
formation d'un capteur de Hall (12) dans le corps ;
formation d'une couche isolante (20) sur ledit corps ;
formation d'un capteur à vanne de flux (11) dans ladite couche isolante, moyennant quoi le capteur de Hall et le capteur à vanne de flux sont intégrés dans une même puce (100), dans lequel l'étape de formation d'un capteur à vanne de flux (11) et d'un capteur de Hall (12) comprend les étapes de :
formation de régions conductrices (19) dans ledit corps ;
formation d'une bobine d'excitation (23) et d'une bobine de détection (22a, 22b) dans ladite couche isolante ; et
formation d'une région magnétique (13) sur ladite couche isolante (20), au-dessus desdites bobines d'excitation et de détection et au-dessus desdites régions conductrices, ladite région magnétique formant à la fois un noyau magnétique pour ledit capteur à vanne de flux et un concentrateur magnétique pour ledit capteur de Hall.

6. Procédé selon la revendication 5, dans lequel les étapes de formation d'une couche isolante, d'une bobine d'excitation et d'une bobine de détection comprennent :
le dépôt d'une couche diélectrique (26-27) ;
le dépôt d'un niveau de métallisation ;
la définition dudit niveau de métallisation pour obtenir ladite bobine de détection (22a, 22b) ;
le dépôt d'une couche diélectrique subséquente (28) ;
le dépôt d'un niveau de métallisation subséquent ;
la définition dudit niveau de métallisation subséquent pour obtenir ladite bobine d'excitation (23) ;
le dépôt d'une couche diélectrique additionnelle (29) ; et
le dépôt par pulvérisation de ladite région magnétique (13).

7. Magnétomètre (40), comprenant le capteur magnétique (10) selon l'une quelconque des revendications 1 à 4 et comprenant une circuiterie d'alimentation/commande de capteur à vanne de flux (41) et une circuiterie d'alimentation/commande de capteur de Hall (42).

8. Magnétomètre selon la revendication 7, dans lequel lesdites circuiteries d'alimentation/commande pour le capteur à vanne de flux et le capteur de Hall (41, 42) sont intégrées dans ladite puce (100).

9. Magnétomètre selon la revendication 7 ou 8, dans lequel la circuiterie d'alimentation/commande de capteur à vanne de flux (41) et la circuiterie d'alimentation/commande de capteur de Hall (42) ont des propres entrées distinctes configurées pour recevoir des signaux de commande distincts externes.

10. Dispositif électronique (50) comprenant une unité de commande (51), un affichage (52) et un magnétomètre (40) selon l'une quelconque des revendications 7 à 9.
